# EUROPÄISCHE PATENTSCHRIFT

(11) **EP 2 190 638 B1**
(45) Veröffentlichungstag und Bekanntmachung des Hinweises auf die Patenterteilung: **30.05.2012**
(21) Anmeldenummer: 08785821.3
(22) Anmeldetag: 04.09.2008
(51) Int. Cl.: B29B 9/06

(54) **VORRICHTUNG ZUM GRANULIEREN VON KUNSTSTOFFSTRÄNGEN**
DEVICE FOR GRANULATING PLASTIC STRANDS
DISPOSITIF POUR LA GRANULATION DE JONCS EN PLASTIQUE

(30) Priorität: 17.09.2007 DE 102007044201
(43) Veröffentlichungstag der Anmeldung: 02.06.2010
(73) Patentinhaber: Automatik Plastics Machinery GmbH, 63762 Grossostheim (DE)
(72) Erfinder: SCHEURICH, Jochen, 63843 Niedernberg (DE)
(74) Vertreter: Bardehle, Heinz
(86) Internationale Anmeldenummer: PCT/EP2008/007228
(87) Internationale Veröffentlichungsnummer: WO 2009/036892

(56) Entgegenhaltungen:
- WO-A-88/06959
- DE-A1- 2 340 682
- DE-U1- 8 600 491

## Beschreibung

Die Erfindung bezieht sich auf eine Vorrichtung zum Granulieren von Kunststoffsträngen mit einer Messerwalze, deren einzelne Messer bei Drehung der Messerwalze an einem in einem Messerträger angeordneten Gegenmesser vorbei streifen und dabei über das Gegenmesser zugeführte Kunststoffstränge zu Granulat zerschneiden, wobei benachbart zu dem Gegenmesser und bezüglich der Drehrichtung der Messerwalze nach dem Gegenmesser eine aus einem harten Material bestehende, parallel zum Gegenmesser verlaufende Schiene angeordnet ist, die geschnittenes Granulat abfängt und in einen Abführkanal leitet.

Eine derartige Vorrichtung ist bereits in der Praxis verwendet worden, und zwar mit der vorstehend erwähnten Schiene, die verhindert, dass durch die Messerwalze abgetrenntes Granulat mit der Geschwindigkeit der Zähne der Messerwalze unterhalb des Gegenmessers auf den Messerträger auftrifft und an diesem durch ständige Reibung mit dem Granulat einen unerwünschten Verschleiß herbeiführt. Durch die Schiene wird dies verhindert, da diese das Granulat abfängt. Ein an der Schiene unvermeidbar auftretender Verschleiß kann dadurch unwirksam gemacht werden, dass rechtzeitig von Zeit zu Zeit die Schiene ausgewechselt wird, die bei bekannten Vorrichtungen an dem Messerträger angeschraubt ist, so dass nach Lösen der Schrauben und Abnahme einer verschlissenen Schiene diese durch eine neue Schiene ersetzt werden kann. Im Zusammenhang mit der Verwendung der Schiene haben sich die Schrauben als nachteilig herausgestellt, da diese einem besonderen Verschleiß ausgesetzt sind. Hinzu kommt, dass die Schiene mit Abstand von dem Gegenmesser befestigt ist, so dass ein Streifen des Materials des Messerträgers dem Aufprall des Granulats ausgesetzt ist und daher einen speziellen Ort des Verschleißes bildet. Wird die Schiene bis an das Gegenmesser herangeführt, so wird dadurch die Auflagefläche des Gegenmessers verkleinert und geschwächt.

Eine entsprechende Gestaltung einer Vorrichtung zum Granulieren von Kunststoffsträngen ist in der DE 23 40 682 beschrieben und dargestellt. Gemäß dieser Druckschrift ist eine geschnittenes Granulat abfangende und weiterleitende Schiene in einer Vorrichtung zum Granulieren von Kunststoffsträngen dargestellt, und zwar in einem Abstand von der Messerwalze, wo sie das Granulat auffängt und weiterleitet.

Der Erfindung liegt die Aufgabe zugrunde, die Schiene so zu gestalten und anzuordnen, dass ihre Auswechslung erleichtert wird und sie so angeordnet wird, dass der Messerträger vor Verschleiß geschützt ist. Erfindungsgemäß geschieht dies dadurch, dass die Schiene in einer Führung mit in Längsrichtung beiderseitigem Hinterschnitt im Messerträger gehalten ist, wobei der dem Gegenmesser zugewandte Hinterschnitt eine Trennleiste bildet, deren Stärke nach außen hin schneidenartig derart abnimmt, dass zusammen mit dem anderen Hinterschnitt die Schiene in Querrichtung eine Schrägstellung zu dem Gegenmesser einnimmt, wobei die dem Gegenmesser zugewandte Aussenkante des Hinterschnitts der gegenüberliegenden Vorderkante des Gegenmessers dicht angenähert ist und die andere Vorderkante der Schiene in Richtung auf die Messerwalze vorspringt.

Durch die Gestaltung der Führung der Schiene mit beiderseitigem Hinterschnitt. beispielsweise also in Form einer Schwalbenschwanzführung, ergibt sich eine leichte Auswechselbarkeit der Schiene, die lediglich in den zwischen den beiden Hinterschnitten gebildeten Kanal einzuschieben ist. Dabei lässt sich die Schiene mit ihren in Längsrichtung verlaufenden beiderseitigen Hinterschnitten so anordnen, dass der dem Gegenmesser zugewandte Rand der Schiene praktisch an dieses heranreicht, so dass zwischen Gegenmesser und Schiene kein Raum mehr für irgendeinen speziellen Verschleiß besteht. Die dabei der Schiene gegebene Schrägstellung gegenüber dem Gegenmesser ermöglicht es, das Abprallen des Granulats an der Schiene so auszurichten, dass das Granulat auf kurzem Wege in dem Abführkanal landet und nicht an weiteren Stellen der Vorrichtung aufprallen kann und damit dort weiteren Verschleiß verursacht.

Zweckmäßig wird die Schiene auf mehrere längs aneinander anschließende Streifen aufgeteilt. Dies erleichtert die Herstellung der Schiene und lässt es darüber hinaus zu, besonders dem Verschleiß ausgesetzte Schienenteile früher auszuwechseln als andere Schienenteile.

In den Figuren ist ein Ausführungsbeispiel der Erfindung dargestellt. Es zeigen:
- Fig. 1: den Messerträger mit Gegenmesser und Schiene mit schwalbenschwanzartiger Halterung in perspektivischer Sicht;
- Fig. 2: eine Seitensicht der Anordnung gemäß Figur 1 in vergrößerter Darstellung;
- Fig. 3: eine Prinzipdarstellung von Messerwalze mit Messerträger und darüber zugeführtem Kunststoffstrang;
- Fig. 4: den Messerträger mit Gegenmesser und Schiene mit abgerundeter Halterung.

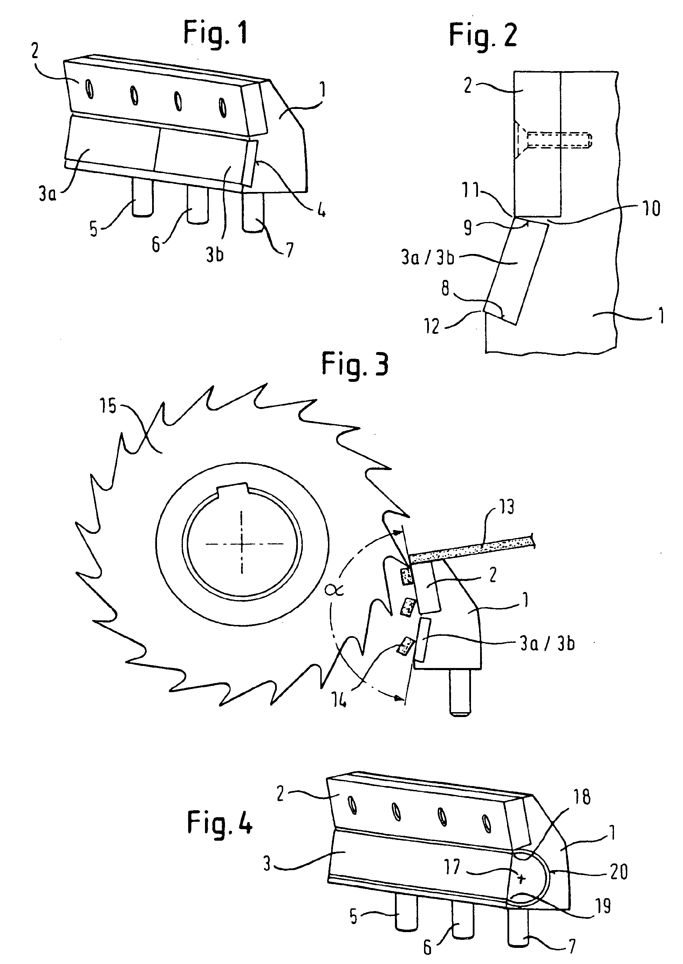

Der in der Figur 1 dargestellte Messerträger 1 weist an seiner Oberseite das an den Messerträger 1 angeschraubte Gegenmesser 2 auf, das aus besonders hartem Material besteht, um damit Verschleiß entgegenzuwirken. Unterhalb des Gegenmessers 2 ist an dem Messerträger 1 die in zwei Teile aufgeteilte Schiene 3a und 3b wiedergegeben, die in eine schwalbenschwanzartige Nut 4 im Messerträger 1 eingeschoben sind. Die Gestaltung der Lagerung der Schiene 3a und 3b in der schwalbenschwanzförmigen Aufnahme ist deutlich der Figur 2 zu entnehmen, auf die weiter unten näher eingegangen wird.

Die Schiene 3a und 3b erstreckt sich längs des Messerträgers 1 über die gesamte Länge des Gegenmessers 2. Die Schiene ist aus fertigungstechnischen Gründen in einzelne Teile, dargestellt Teile 3a und 3b, aufgeteilt, um gegebenenfalls einzelne Teile wegen möglichen Verschleißes früher auszutauschen als andere Teile. Der Messerträger 1 besitzt nach unten hin herausragende Bolzen 5, 6 und 7 (bei entsprechender Länge des Messerträgers 1 weitere Bolzen), die in ein Maschinengestell der hier zugrundeliegenden Vorrichtung zum Granulieren von Kunststoffsträngen eingepasst sind und für die Halterung des Messerträgers 1 im Maschinengestell sorgt.

Die in der Figur 2 dargestellte Seitensicht des Messerträgers 1 mit dem Gegenmesser 2 und der Schiene 3a/3b zeigt die Schwalbenschwanzführung für die Schiene 3a/3b. Die Führung für die Schiene 3a/3b weist auf deren nach unten gerichteten Seite den Hinterschnitt 8 und auf ihrer dem Gegenmesser 2 zugewandten Seite den Hinterschnitt 9 auf, wobei beide Hinterschnitte eine Schwalbenschwanzführung bilden, durch die die Schiene 3a/3b fest in dem Gegenmesser 1 gehalten wird. Dabei ist der Hinterschnitt 9 so gelegt und gestaltet, dass die zwischen der Seite der Schiene 3a/3b und dem unteren Ende des Gegenmessers 2 gebildete Trennleiste 10 nach außen hin schneidenartig abnimmt, womit einerseits nach außen hin in Richtung zur Messerwalze 15 (siehe Figur 3) die betreffende Außenkante 11 des Gegenmessers und die Trennleisten 9 schneidenartig zusammenlaufen, so dass in Richtung auf die Messerwalze praktisch nur ein so schmaler Streifen des Materials des Messerträgers 1 hervortritt, dass an dieser Stelle praktisch Verschleiß durch Aufprallen des Granulats nicht entstehen kann, da dieses entweder von dem unteren Teil des Gegenmessers 2 oder von der Schiene 3a/3b abgefangen wird. Wie ersichtlich springt dabei die untere Vorderkante 12 der Schiene 3a/3b in Richtung auf die Messerwalze vor, wodurch sich einerseits der vorstehend erläuterte Effekt der schneidenartig in ihrer Dicke abnehmenden Trennleiste entsteht und andererseits die Schiene 3a/3b so vorspringt, dass auf ihr auftretendes Granulat (siehe Figur 3) von dem Messerträger 1 weg direkt in einen Abführkanal geleitet wird.

In der Figur 3 sind die in diesem Zusammenhang relevanten Bauelemente einer Vorrichtung zum Granulieren von Kunststoffsträngen dargestellt, wobei es sich bei der Messerwalze, dem Gegenmesser und dem Messerträger um bekannte Bauteile handelt, die auch in der angegebenen Struktur im Stand der Technik enthalten sind. Wie die Figur 3 zeigt, wird durch die Messerwalze von dem Strang 13 abgeschnittenes Granulat auf die Schiene 3a/3b gelenkt, das auf der Schiene 3a/3b in flacher Kurve auftrifft und daher keine besonders große Reibung verursachen kann. Das ausgesucht harte Material der Schiene 3a/3b sorgt dann dafür, dass auch ständiges Beaufschlagen der Schiene 3a und 3b mit abgeschnittenem Granulat die Schiene nur geringfügig aushöhlen kann, was bei längerem Betrieb dadurch ausgeglichen werden kann, dass einzelne Schienenteile ausgewechselt werden, indem die alten aus der Schwalbenschwanzführung herausgenommen und neue Schienenteile in die Schwalbenschwanzführung eingeschoben werden. In der Figur 3 ist der Winkel α, der sich zwischen den Oberflächen des Gegenmessers 2 und der Schiene 3a/3b ergibt, in dem strichpunktiert eingezeichneten Kreisbogen angegeben, wie die Schrägstellung von Schiene 3a/3b zum Gegenmesser 2 verläuft.

In der Figur 4 ist eine Variante hinsichtlich der Gestaltung der Schiene wiedergegeben. Gemäß Figur 4 ist in den Messerträger 1 für die Schiene 3 die Nut 20 eingelassen, die hier im Querschnitt einem Kreisabschnitt entspricht, der zur Öffnungsseite hin jeweils in einem Hinterschnitt endet und der zu den nach innen eingezogenen Kanten 18 und 19 führt, womit sich auch hier die Wirkung einer Schwalbenschwanzführung ergibt. Die derart mit den eingezogenen Kanten 18 und 19 eingebrachte Nut 20 hält die eine entsprechenden halbrunden Querschnitt aufweisende Schiene 3 sicher in sich fest, so dass diese für die Auswechslung bloß seitlich herausgeschoben werden muss. Hinsichtlich der Funktion der Schiene 3 gemäß Figur 4 sei auf die Erläuterung zu den vorstehenden Figuren verwiesen.

## Patentansprüche

1. Vorrichtung zum Granulieren von Kunststoffsträngen mit einer Messerwalze (15), deren einzelne Messer bei Drehung der Messerwalze (15) an einem in einem Messerträger (1) angeordneten Gegenmesser (2) vorbei streifen und dabei über das Gegenmesser (2) zugeführte Kunststoffstränge (13) zu Granulat (14) zerschneiden, wobei benachbart zu dem Gegenmesser (2) und bezüglich der Drehrichtung der Messerwalze (15) nach dem Gegenmesser (2) eine aus einem harten Material bestehende, parallel zum Gegenmesser verlaufende Schiene (3a, 3b) angeordnet ist, die geschnittenes Granulat (14) abfängt und in einen Abführkanal leitet, **dadurch gekennzeichnet, dass** die Schiene (3a, 3b) in einer Führung mit in Längsrichtung beiderseitigem Hinterschnitt (8, 9) im Messerträger (1) gehalten ist, wobei der dem Gegenmesser (2) zugewandte Hinterschnitt (9) eine Trennleiste (10) bildet, deren Stärke nach außen hin schneidenartig derart abnimmt, dass zusammen mit dem anderen Hinterschnitt (8) die Schiene (3a, 3b) in Querrichtung eine Schrägstellung zu dem Gegenmesser (2) einnimmt, wobei die dem Gegenmesser (2) zugewandte Aussenkante (11) des Hinterschnitts (9) der gegenüberliegenden Vorderkante des Gegenmessers (2) dicht angenähert ist und die andere Vorderkante (12) der Schiene in Richtung auf die Messerwalze vorspringt.

2. Granulator nach Anspruch 1, **dadurch gekennzeichnet, dass** die Schiene auf mehrere längs aneinander anschließende Streifen (3a, 3b) aufgeteilt ist.

## Claims

1. Device for granulating plastic strands having a cutting wheel (15), the individual blades of which, on rotation of the cutting wheel (15), graze pass a counter blade (2) disposed in a blade carrier (1), and are cutting the plastic strands (13) being guided over the counter blade (2) into a granulate (14), wherein a rail (3a,3b) composed of hard material running parallel to the counter blade is disposed adjacent to the counter blade (2) and after the counter blade (2) in the rotational direction of the cutting wheel (15) that collects cut granulate and conducts that granulate into a discharge channel, **characterized in that** the rail (3a, 3b) is held in a guide having an undercut (8, 9) in the blade carrier (1) on both sides in longitudinal direction, wherein the undercut (9) facing the counter blade (2) forms a separating strip (10), the thickness of which reduces outwards in a blade-like fashion such that, along with the other undercut (8), the rail (3a, 3b) assumes an oblique position relative to the counter blade (2) in the transverse direction, and wherein the outer edge (11) of the undercut (9) facing the counter blade (2) is in close proximity to the opposite front edge of the counter blade (2) and the other front edge (12) of the rail protrudes in the direction of the cutting wheel.

2. Granulator according to claim 1, **characterized in that** the rail is divided up into several strips (3a, 3b) arranged longitudinally engaging one another.

## Revendications

1. Dispositif destiné à granuler des boudins en plastique avec un arbre porte-lames (15) dont les lames individuelles effleurent lors de la rotation de l'arbre porte-lames (15) devant un outil à entailler (2) placé sur un support de lame (1) et découpent alors sous forme de granulat (14) les boudins en plastique (13) amenés, par l'intermédiaire de l'outil à entailler (2), sachant que de manière contiguë à l'outil à entailler (2) et en ce qui concerne le sens de rotation de l'arbre porte-lames (15) après l'outil à entailler (2), un rail (3a, 3b) d'une matière dure placé en s'étendant parallèlement à l'outil à entailler recueille le granulat découpé (14) et le conduit dans un canal d'évacuation, **caractérisé en ce que** le rail (3a, 3b) est tenu dans le support de lame dans un guidage avec une contre-dépouille dans le sens longitudinal des deux côtés, sachant que la contre-dépouille tournée vers l'outil à entailler (2) forme un listeau de séparation (10) dont l'épaisseur vers l'extérieur diminue sous forme de coupure de telle manière qu'avec l'autre contre-dépouille (8) le rail (3a, 3b) adopte une position en biais par rapport à l'outil à entailler (2) dans le sens transversal, sachant que l'arête extérieure (11) de la contre-dépouille (9) tournée vers l'outil à entailler (2), qui est fortement rapprochée de l'arête avant opposée de l'outil à entailler (2) et l'autre arête avant (12) du rail est en saillie en direction de l'arbre porte-lames.

2. Granulateur selon revendication 1 **caractérisé en ce que** le rail est divisé sur plusieurs bandes (3a, 3b) jointes les unes aux autres dans le sens de la longueur.
